(19) Europäisches Patentamt
European Patent Office
Office européen des brevets

(11) Veröffentlichungsnummer: **0 287 818 B1**

(12) **EUROPÄISCHE PATENTSCHRIFT**

(45) Veröffentlichungstag der Patentschrift: **26.05.93**

(21) Anmeldenummer: **88104466.3**

(22) Anmeldetag: **21.03.88**

(51) Int. Cl.$^5$: **C07C 271/06**, C07C 271/08, C07C 323/50, C07D 211/22, G03F 7/027

(54) **Polymerisierbare Verbindungen und diese enthaltendes durch Strahlung polymerisierbares Gemisch.**

(30) Priorität: **28.03.87 DE 3710279**

(43) Veröffentlichungstag der Anmeldung:
**26.10.88 Patentblatt 88/43**

(45) Bekanntmachung des Hinweises auf die Patenterteilung:
**26.05.93 Patentblatt 93/21**

(84) Benannte Vertragsstaaten:
**DE FR GB NL**

(56) Entgegenhaltungen:
**EP-A- 0 005 750**
**DE-A- 2 519 008**
**US-A- 3 996 237**

(73) Patentinhaber: **HOECHST AKTIENGESELLSCHAFT**
**Postfach 80 03 20**
**W-6230 Frankfurt am Main 80(DE)**

(72) Erfinder: **Rode, Klaus, Dr.**
**Habelstrasse 5**
**W-6200 Wiesbaden(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.6/3.3.1)

## Beschreibung

Die Erfindung betrifft neue polymerisierbare Verbindungen mit mindestens zwei Acryl- oder Alkacrylsäureestergruppen im Molekül sowie ein durch Strahlung, insbesondere Licht, polymerisierbares Gemisch, das diese Verbindungen enthält.

Photopolymerisierbare Gemische, die als polymerisierbare Verbindungen Acryl- und/oder Methacrylsäureester enthalten, sind bekannt. Für die Herstellung von Photoresistmaterialien, insbesondere von Trockenphotoresistschichten, werden dabei Gemische bevorzugt, die Acryl- oder Methacrylsäureester mit Urethangruppen im Molekül enthalten und die sich mit wäßrig-alkalischen Lösungen entwickeln lassen. Derartige Gemische sind z. B. in der DE-A 28 22 190, der DE-B 21 15 373, der DE-C 23 61 041 und den US-A 3 850 770 und 3 960 572 beschrieben.

Andererseits sind auch photopolymerisierbare Gemische bekannt, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten. Derartige synergistisch wirkende Gemische sind z. B. in den DE-A 26 02 419 und 22 51 048 und der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N′,N′-Tetrahydroxyalkyl-alkylendiamins enthält. Die tetrafunktionelle Verbindung dient als Vernetzungsmittel.

Aufgabe der Erfindung war es, polymerisierbare Acryl- oder Alkacrylsäureester bereitzustellen, die sich zur Verwendung in durch Strahlung polymerisierbaren Gemischen, insbesondere photopolymerisierbaren Gemischen eignen und die polymerisierbare Gemische hoher Strahlungsempfindlichkeit ergeben, ohne daß Zusätze von niedermolekularen flüchtigen oder leicht diffundierenden Bestandteilen erforderlich sind.

Erfindungsgemäß wird eine Verbindung der allgemeinen Formel I

$$R_{(m-n)}Q[(-CH_2-\overset{R^1}{\underset{R^2}{C}}O)_a-CONH(X^1-NHCOO)_b-X^2(-OOC-\overset{R^3}{C}=CH_2)_c]_n \qquad (I)$$

worin

Q

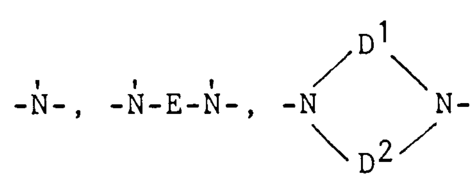

oder -S-

R eine Alkyl-, Hydroxyalkyl- oder Arylgruppe,

$R^1$ und $R^2$ jeweils ein Wasserstoffatom, eine Alkylgruppe oder Alkoxyalkylgruppe,

$R^3$ ein Wasserstoffatom, eine Methyl- oder Ethylgruppe,

$X^1$ eine gesättigte Kohlenwasserstoffgruppe mit 2 bis 12 Kohlenstoffatomen,

$X^2$ eine (c+1)-wertige gesättigte Kohlenwasserstoffgruppe, in der bis zu 5 Methylengruppen durch Sauerstoffatome ersetzt sein können,

$D^1$ und $D^2$ jeweils eine gesättigte Kohlenwasserstoffgruppe mit 1 bis 5 Kohlenstoffatomen,

E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,

a 0 oder eine ganze Zahl von 1 bis 4,

b 0 oder 1,
c eine ganze Zahl von 1 bis 3,
m je nach Wertigkeit von Q 2, 3 oder 4 und
n eine ganze Zahl von 1 bis m

bedeutet, wobei alle Reste gleicher Definition untereinander gleich oder verschieden sein können.

Erfindungsgemäß wird ferner ein durch Strahlung polymerisierbares Gemisch vorgeschlagen, das als wesentliche Bestandteile

a) ein polymeres Bindemittel,
b) einen Acryl – oder Alkacrylsäureester eines mehrwertigen Urethangruppen enthaltenden Alkohols und
c) eine Verbindung oder eine Verbindungskombination, die unter Einwirkung aktinischer Strahlung die Polymerisation der Verbindung b) zu initiieren vermag,

enthält.

Das erfindungsgemäße Gemisch ist dadurch gekennzeichnet, daß der Acryl – oder Alkacrylsäureester eine Verbindung der vorstehend angegebenen allgemeinen Formel I ist.

Erfindungsgemäß wird weiterhin ein durch Strahlung polymerisierbares Aufzeichnungsmaterial mit einem Schichtträger und einer durch Strahlung polymerisierbaren Schicht vorgeschlagen, die aus einem Gemisch der vorstehend genannten Zusammensetzung besteht.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl – oder Hydroxyalkylgruppe ist, hat diese im allgemeinen 2 bis 8, vorzugsweise 2 bis 4 Kohlenstoffatome. Der Arylrest R kann im allgemeinen ein – oder zweikernig, bevorzugt einkernig und gegebenenfalls durch Alkyl – oder Alkoxygruppen mit bis zu 5 Kohlenstoffatomen oder Halogenatome substituiert sein.

Wenn $R^1$ und $R^2$ Alkyl – oder Alkoxyalkylgruppen sind, können diese 1 bis 5 Kohlenstoffatome enthalten.

$R^3$ ist bevorzugt ein Wasserstoffatom oder eine Methylgruppe, insbesondere eine Methylgruppe.

$X^1$ ist bevorzugt ein geradkettiger oder verzweigter aliphatischer oder cycloaliphatischer Rest mit vorzugsweise 4 bis 10 Kohlenstoffatomen.

$X^2$ hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. $X^2$ kann auch eine cycloaliphatische Gruppe mit 5 bis 10 Kohlenstoffatomen, insbesondere eine Cyclohexylgruppe sein.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I mit Q = N und n = m, die zwei Urethangruppen in jedem Rest (b = 1) enthalten, werden dargestellt, indem Acryl – oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen umgesetzt wird. Wenn a = 0 ist, entsteht eine Harnstoffgruppierung.

Die als Ausgangsstoffe verwendeten Hydroxyalkylamine sind bekannt oder analog bekannten Verbin – dungen herzustellen. Beispiele sind Verbindungen, die durch Anlagerung von Ethylenoxid bzw. von höheren Alkylenoxiden an Ammoniak oder Amine entstehen; z. B. Triethanolamin, N – Alkyl – N,N – di(hydroxyalkyl) – amine, Diethanolamin, Tris – (2 – hydroxypropyl)amin oder Tris – (2 – hydroxybutyl)amin.

Die als Ausgangsstoffe verwendeten Diisocyanate sind bekannt oder analog bekannten Verbindungen herzustellen. Beispiele sind Ethylendiisocyanat, Propylendiisocyanat, Butylen – 1,3 – diisocyanat, Hexame – thylendiisocyanat, 2,2,4 – Trimethyl – hexamethylendiisocyanat, 2,4 – Dimethyl – 6 – ethyl – octamethylendii – socyanat, 1,4 – Cyclohexylendiisocyanat, 1,3 – Cyclopentylendiisocyanat, 1,4 – Diisocyanatomethyl – cyclo – hexan und 1,1,3 – Trimethyl – 3 – isocyanatomethyl – 5 – isocyanatocyclohexan.

Als Hydroxygruppen enthaltende Ester werden insbesondere Hydroxyethylmethacrylat und Hydrox – ypropylmethacrylat (n oder iso) sowie ferner die entsprechenden Acrylate verwendet, da sie die einfachsten

Vertreter dieser Verbindungsgruppe sind. Mit Vorteil können jedoch auch folgende Verbindungen verwendet werden: 2-Hydroxy-butylmethacrylat, 4-Hydroxy-butylmethacrylat, 2-Hydroxy-cyclohexylmethacrylat und andere Hydroxy-alkylmethacrylate mit bis zu 12, vorzugsweise bis zu 6 Kohlenstoffatomen im Alkylrest, Diethylenglykolmonomethacrylat, Triethylenglykolmonomethacrylat und andere Polyethylenglykolmonomethacrylate mit bis zu 5 Oxyethyleneinheiten, Trimethylolethandimethacrylat, Trimethylolpropandimethacrylat, Pentaerythrittrimethacrylat sowie die aus der DE-B 1 267 547 bekannten Umsetzungsprodukte dieser verzweigten mehrwertigen Ester mit bis zu 4 mol Alkylenoxid, insbesondere Ethylenoxid, sowie die entsprechenden Acrylate.

Die bevorzugten polymerisierbaren Verbindungen der Formel I mit n = 3 und b = 0 werden wie folgt dargestellt: Die oben beschriebenen Hydroxyalkylamine werden mit Isocyanatgruppen enthaltenden Acryl- oder Alkylacrylsäureestern umgesetzt.

Als Isocyanatgruppen enthaltender Ester wird insbesondere Isocyanatoethyl(meth)acrylat eingesetzt, da es der einfachste Vertreter dieser Verbindungsgruppe ist. Mit Vorteil können jedoch auch folgende Verbindungen verwendet werden: 3-Isocyanatopropylmethacrylat, 4-Isocyanatobutylmethacrylat, Isocyanatoisohexylmethacrylat und andere Isocyanatoalkyl(meth)acrylate mit bis zu 12, vorzugsweise bis zu 6 Kohlenstoffatomen im Alkylrest.

Die bevorzugten polymerisierbaren Verbindungen der Formel I mit

$$Q = -\overset{|}{N}-E-\overset{|}{N}-,$$

n = 4 und b = 1 oder b = 0
werden analog den polymerisierbaren Verbindungen mit Q = N hergestellt. Die als Ausgangsstoffe verwendeten Tetrahydroxyalkyl-alkylendiamine sind bekannt oder analog zu bekannten Verbindungen herzustellen.

Beispiele sind Verbindungen, die durch Anlagerung von Ethylenoxid oder höheren Alkylenoxiden an Diaminoverbindungen entstehen, wie Ethylendiamin und andere Alkylendiamine mit bis zu 12, vorzugsweise bis zu 6 Kohlenstoffatomen im Alkylenrest, p-Phenylendiamin, Benzidin, Diaminopyridine, Diaminopyrimidine, Diaminopurine.

Die polymerisierbaren Verbindungen der Formel I mit

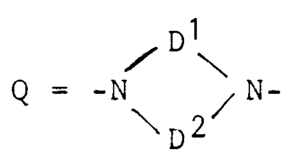

und b = 1 oder b = 0
werden analog den oben beschriebenen polymerisierbaren Verbindungen hergestellt. Die als Ausgangsstoffe verwendeten N-Hydroxyalkylheterocyclen sind bekannt oder analog zu bekannten Verbindungen herzustellen. Beispiele sind Umsetzungsprodukte des Ethylenoxids mit Piperazin, 1,4-Diazacycloheptan, 1,10-Diaza-4,7,13,16-tetraoxacyclooctadecan. Insbesondere wird Piperazin eingesetzt, da es der einfachste Vertreter dieser Verbindungsgruppe ist.

Die Umsetzung der Isocyanate mit den OH-Gruppen enthaltenden Aminen und Alkylacrylaten wird zweckmäßig in einem inerten Lösungsmittel wie Toluol, Pyridin oder Methylethylketon durchgeführt. Zur thermischen Stabilisierung der stark zur Polymerisation neigenden Produkte werden Chinone, vorzugsweise Benzochinon, in Konzentrationen von 0.01 - 2 Gew.-% zugesetzt.

Die erfindungsgemäßen Verbindungen mit Q = S werden, ausgehend vom entsprechenden Bis-hydroxyalkyl-sulfid, analog den oben angegebenen allgemeinen Vorschriften hergestellt.

Ein wesentlicher Vorteil der erfindungsgemäßen Verbindungen besteht darin, daß sie, insbesondere diejenigen mit m = n, für die sehr hohe Lichtempfindlichkeit der damit erhaltenen photopolymerisierbaren Gemische verantwortlich sind.

Den erfindungsgemäßen Verbindungen können mit Vorteil auch herkömmliche polymerisierbare Verbindungen, die zwei oder mehr polymerisierbare Acryl- oder Methacrylsäureestergruppen enthalten, zugesetzt werden, wobei selbstverständlich zu beachten ist, daß durch diese die durch Verwendung der neuen polymerisierbaren Verbindungen erzielten, oben erläuterten Vorteile nicht zu stark herabgesetzt

werden.

Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil der Schicht an Monomeren beträgt im allgemeinen etwa 10 bis 80, vorzugsweise 20 bis 60 Gew.-%.

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: $-COOH$, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:
Inhibitoren zur Verhinderung der thermischen Polymerisation der Monomeren,
Wasserstoffdonatoren,
die sensitometrischen Eigenschaften derartiger Schichten modifizierende Stoffe,
Farbstoffe,
gefärbte und ungefärbte Pigmente,
Weichmacher, z.B. Polyglykole oder Ester der p-Hydroxybenzoesäure.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des kurzwelligen sichtbaren Lichts entspricht. Geeignet ist sichtbares Licht, langwellige und kurzwellige UV-Strahlung, Laserstrahlung, Elektronen- und Röntgenstrahlung.

Als Photoinitiatoren in dem erfindungsgemäßen Gemisch können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Die Initiatoren werden allgemein in einer Menge von 0,01 bis 10, vorzugsweise von 0,05 bis 4 Gew.-%, bezogen auf die nichtflüchtigen Bestandteile des Gemischs, eingesetzt.

Wenn die Bebilderung mit Elektronenstrahlen durchgeführt wird, sind neben den bekannten für sichtbares und nahes UV-Licht empfindlichen Photoinitiatoren auch solche geeignet, deren Absorptionsbereiche im kurzwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß man die Materialien besser lagerfähig machen kann. Als Beispiele für derartige Starter sind Tribrommethyl-phenylsulfon, 2,2',4,4',6,6'-Hexabromdiphenylamin, Pentabromethan, 2,3,4,5-Tetrachloranilin, Pentaerythrittetrabromid, Chlorterphenylharze oder chlorierte Paraffine zu nennen.

Als Wasserstoffdonatoren werden in der Hauptsache aliphatische Polyether verwendet. Gegebenenfalls kann diese Funktion auch vom Bindemittel übernommen werden, wenn dieses labile Wasserstoffatome besitzt, oder diese Funktion wird ganz von den erfindungsgemäßen neuen Monomeren übernommen.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Flachdruckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen, Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw..

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösungsmittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Dabei wird zunächst die Herstellung einer Anzahl neuer polymerisierbarer Verbindungen beschrieben. Die Verbindungen werden in den nachfolgenden Beispielen in erfindungsgemäßen Aufzeichnungsmaterialien als polymerisierbare Verbindungen eingesetzt. In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

1.) Allgemeine Vorschrift zur Darstellung der Verbindungen der allgemeinen Formel I mit b = 0 (Verbindungen 1 – 5 und 16 – 21 in Tabelle I)

Die Hydroxyalkylgruppen enthaltende Aminoverbindung und das Isocyanatoalkyl(meth)acrylat werden in gewünschten Molverhältnis in der zehnfachen Menge des geeigneten Lösungsmittels (Toluol, Butanon, Pyridin) mit 0,01 Gew. – % Dibutylzinndilaurat und 0,01 Gew. – % Benzochinon solange unter Rückfluß erhitzt, bis die Isocyanatbande (2275 – 2250 $cm^{-1}$) IR – spektroskopisch nicht mehr nachzuweisen ist (in der Regel nach 5 bis 8 Stunden). Anschließend wird das Lösungsmittel im Vakuum bei 50° C abdestilliert. Die ungesättigte Verbindung verbleibt als viskoser Rückstand in praktisch quantitativer Ausbeute.

2.) Allgemeine Vorschrift zur Darstellung der Verbindungen der allgemeinen Formel I mit b = 1 (Verbindungen 6 – 15 in Tabelle I)

Hydroxyalkyl(meth)acrylat und Diisocyanat werden im Molverhältnis 1:1 in der zehnfachen Menge Lösungsmittel (Toluol, Butanon, Pyridin) mit 0,01 Gew. – % Dibutylzinndilaurat und 0,01 Gew. – % Benzochinon 8 Stunden unter Rückfluß erhitzt und anschließend die gewünschte Molmenge Hydroxyalkylamin zugegeben und solange weiter unter Rückfluß erhitzt, bis die Isocyanatbande IR – spektroskopisch verschwunden ist (in der Regel 5 – 8 Stunden). Anschließend wird das Lösungsmittel im Vakuum bei 50° C abdestilliert. Die ungesättigte Verbindung verbleibt als viskoser Rückstand in praktisch quantitativer Ausbeute.

Die so hergestellten ungesättigten Verbindungen 1 bis 21 sind in Tabelle 1 angegeben.

## Tabelle I

Verbindungen der allgemeinen Formel I mit $R^2$=H; $R^3$=$CH_3$

| Verb. Nr. | Q | R | $R^1$ | a | $X^1$ | b | $X^2$ | m | n | $N_{ber.}$ | $N_{gef.}$ |
|---|---|---|---|---|---|---|---|---|---|---|---|
| 1 | -N- | - | H | 1 | - | 0 | $C_2H_4$ | 3 | 3 | 9,1 | 8,8 |
| 2 | -N- | $C_2H_4OH$ | H | 1 | - | 0 | " | 3 | 2 | 10,1 | 9,5 |
| | | | - | 0 | - | 0 | " | | | | |
| 3 | **) | - | H | 1 | - | 0 | " | 2 | 2 | 11,6 | 11,9 |
| 4 | $-N-CH_2-CH_2-N-$ | - | $CH_3$ | 1 | - | 0 | " | 4 | 4 | 9,1 | 8,8 |
| 5 | " | - | H | 1 | - | 0 | " | 4 | 4 | - | - |
| 6 | -N- | - | H | 1 | *) | 1 | " | 3 | 3 | 8,4 | 8,7 |
| 7 | **) | - | H | 1 | *) | 1 | " | 2 | 2 | - | - |
| 8 | $-N-CH_2CH_2-N-$ | - | $CH_3$ | 1 | *) | 1 | " | 4 | 4 | 8,5 | 8,3 |
| 9 | $-N-CH_2CH_2-N-$ | - | H | 1 | *) | 1 | $C_2H_4$ | 4 | 4 | - | - |
| 10 | **) | - | H | 1 | *) | 1 | $C_3H_6$ | 2 | 2 | - | - |
| 11 | $-N-CH_2CH_2-N-$ | - | H | 1 | *) | 1 | $C_3H_6$ | 4 | 4 | - | - |

| Verb. Nr. | Q | R | $R^1$ | a | $X^1$ | b | $X^2$ | m | n | $N_{ber.}$ | $N_{gef.}$ |
|---|---|---|---|---|---|---|---|---|---|---|---|
| 12 | -N- | - | H | 1 | *) | 1 | $C_3H_6$ | 3 | 3 | - | - |
| 13 | **) | - | H | 1 | $C_6H_{12}$ | 1 | $C_2H_4$ | 2 | 2 | - | - |
| 14 | $-N-CH_2-CH_2-N-$ | - | $CH_3$ | 1 | " | 1 | " | 4 | 4 | - | - |
| 15 | " | - | H | 1 | " | 1 | " | 4 | 4 | 8,0 | 8,2 |
| 16 | -S- | - | H | 1 | - | 0 | $C_2H_4$ | 2 | 2 | - | - |
| 17 | -N- | - | $CH_3OCH_2$ | 1 | - | 0 | " | 3 | 3 | - | - |
| 18 | $-N-CH_2-CH_2-N-$ | $C_2H_4OH$ | H | 1 | - | 0 | " | 4 | 3 | - | - |
| 19 | -N- | $C_6H_5$ | H | 1 | - | 0 | " | 3 | 2 | - | - |
| 20 | -N- | - | H | 2 | - | 0 | " | 3 | 3 | - | - |
| 21 | -N- | $\left\{ \begin{matrix} CH_3 \\ C_2H_4OH \end{matrix} \right\}$ | H | 1 | - | 0 | " | 3 | 1 | - | - |
| 22*** | -N- | - | H | 1 | $C_6H_{12}$ | 1 | $C_3H_6$ | 3 | 3 | - | - |

*) 2,2,4-Trimethyl-hexamethylen

**) Piperidin-1,4-diyl

*** $R^3$ = H

Beispiel 1

Als Schichtträger für Druckplatten wurde elektrochemisch aufgerauhtes und anodisiertes Aluminium mit einer Oxidschicht von 3 $g/m^2$ verwendet, das mit einer wäßrigen Lösung von Polyvinylphosphonsäure vorbehandelt worden war. Der Träger wurde mit einer Lösung folgender Zusammensetzung überzogen:

5,85 Gt einer 33,4 %igen Lösung eines Methylmethacrylat/Methacrylsäure-Mischpolymerisats mit der Säurezahl 110 und dem mittleren Molgewicht 35 000 in Methylethylketon,

1,0 Gt einer der Verbindungen 1 bis 14,

1,0 Gt Trimethylolethantriacrylat,

0,035 Gt 9-Phenyl-acridin und

0,02 Gt des Azofarbstoffs aus 2,4-Dinitro-6-chlorbenzoldiazoniumsalz und 2-Methoxy-5-acetylamino-N-cyanoethyl-N-hydroxyethylanilin in
26 Gt Propylenglykolmonomethylether.

Das Auftragen erfolgte durch Aufschleudern in der Weise, daß ein Trockengewicht von 2,8 bis 3 g/$m^2$ erhalten wurde. Anschließend wurde die Platte zwei Minuten bei 100° C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis 5 g/$m^2$ erhalten. Die erhaltene Druckplatte wurde mittels einer 5 kW-Metallhalogenidlampe im Abstand von 110 cm unter einem 13-stufigen Belichtungskeil mit Dichteinkrementen von 0,15 30 Sekunden belichtet.

Anschließend wurde die Platte mit einem Entwickler folgender Zusammensetzung entwickelt:
120 Gt Natriummetasilikat • 9 $H_2O$,
2,13 Gt Strontiumchlorid,
1,2 Gt nichtionogenes Netzmittel (Kokosfettalkohol-Polyoxyethylenether mit ca. 8 Oxyethyleneinheiten) und
0,12 Gt Antischaummittel in
4000 Gt vollentsalztem Wasser.

Die Platte wurde mit fetter Druckfarbe eingefärbt. Es wurden die folgenden vollvernetzten Keilstufen erhalten.

| Verbindung Nr. | Keilstufen | Verbindung Nr. | Keilstufen |
|---|---|---|---|
| 1 | 4 | 8 | 4 |
| 2 | 6 | 9 | 4 |
| 3 | 1 | 10 | 3 |
| 4 | 4 | 11 | 4 |
| 5 | 4 | 12 | 3 |
| 6 | 4 | 13 | 4 |
| 7 | 3 | 14 | 4 |

Beispiel 2

Auf den in Beispiel 1 angegebenen Schichtträger wurde unter gleichen Bedingungen wie im Beispiel 1 eine Lösung folgender Zusammensetzung aufgeschleudert:
5,85 Gt der in Beispiel 1 angegebenen Mischpolymerisatlösung,
2,0 Gt Monomeres,
0,035 Gt 9-Phenylacridin und
0,02 Gt des in Beispiel 1 angegebenen Azofarbstoffs in
26,0 Gt Propylenglykolmonomethylether.

Nach Auftragen einer Deckschicht aus Polyvinylalkohol wurde die Platte in gleicher Weise wie in Beispiel 1 belichtet und weiterverarbeitet.

Es wurde die folgende Anzahl vollvernetzter Keilstufen erhalten:

| Verbindung Nr. | Keilstufen |
|---|---|
| 1 | 6 |
| 2 | 7 |
| 4 | 2 |
| 5 | 2 |
| 13 | 5 |
| 14 | 5 |
| 16 | 7 |

Wenn anstelle der vorstehend angegebenen polymerisierbaren Verbindungen, die sämtlich Methacrylsäureester sind, ein Acrylsäureester, die Verbindung 22, eingesetzt wird, wird die Schicht unter sonst gleichen Bedingungen weniger durchgehärtet.

Beispiel 3

Auf den in Beispiel 1 angegebenen Schichtträger wurde unter gleichen Bedingungen wie dort eine Lösung folgender Zusammensetzung aufgeschleudert:
6,1 Gt einer 22,3 %igen Lösung eines Terpolymerisats aus Styrol, n-Hexylmethacrylat und Methacrylsäure (10:60:30) mit der Säurezahl 190 in Butanon,
1,4 Gt Verbindung 1,
0,049 Gt 9-Phenylacridin,
0,007 Gt eines Azofarbstoffs aus 2-Diazo-6-nitrobenzthiazol und N-Cyanoethyl-N-ethyl-3-methyl-anilin und
0,120 Gt 2-Mercaptobenzimidazol in
46,0 Gt Propylenglykolmonomethylether
Die beschichtete Platte wurde anschließend 2 Minuten bei 100° C im Umlufttrockenschrank getrocknet und mit einer Deckschicht wie im Beispiel 1 versehen. Die Platte wurde unter einem 13-stufigen Belichtungskeil, auf den zusätzlich ein Silberfilm mit gleichmäßiger Schwärzung (Dichte 1,5) und gleichmäßiger Absorption über den wirksamen Spektralbereich montiert wurde, 40 Sekunden belichtet, anschließend 1 Minute im Umlufttrockenschrank auf 100° C nacherwärmt und wie im Beispiel 1 entwickelt und beurteilt. Es wurden 4 Keilstufen erhalten.

Beispiel 4

Auf eine 125 µm dicke Polyethylenterephthalatfolie wurde eine Schicht folgender Zusammensetzung so gegossen, daß nach dem Trocknen eine Schichtdicke von 3,5 mm erhalten wurde:
90,0 Gt eines Styrol/Isopren/Styrol-Dreiblock-Copolymeren mit je 7,5 % Polystyrol an den Enden, Molekulargewicht 100 000,
10,0 Gt Verbindung 1,
2,0 Gt Benzildimethylketal und
0,3 Gt Di-tert.-butylkresol in
100,0 Gt Toluol.

Nach 50 Minuten Rückseitenbelichtung ohne Vorlage und 80 Minuten Belichtung der Vorderseite durch eine Bildvorlage in einem Flachbelichter mit UVA-Leuchtstofflampen wurde mit einem Gemisch aus 4 Volumteilen Perchlorethylen und 1 Volumteil n-Butanol entwickelt. Es wurde eine flexible Druckform mit scharfer, 1 mm tiefer Reliefstruktur erhalten.

Beispiel 5

Auf den in Beispiel 1 angegebenen Schichtträger wurde eine Lösung folgender Zusammensetzung so aufgeschleudert, daß nach dem Trocknen ein Schichtgewicht von 3 $g/m^2$ erhalten wurde:
5,85 Gt der in Beispiel 1 angegebenen Mischpolymerisatlösung,
2,0 Gt Verbindung 1,
0,035 Gt 9-Phenylacridin,
0,02 Gt des in Beispiel 1 angegebenen Azofarbstoffs und
0,035 Gt 4-Dimethylamino-4'-methoxydibenzalaceton in
26,0 Gt Propylenglykolmonomethylether.

Nach Trocknen und Aufbringen der Deckschicht wie in Beispiel 1 wurde die Platte 40 Sekunden belichtet. Durch Entwickeln wie in Beispiel 1 wurden 2 gedeckte Stufen erhalten.

Beispiel 6

In diesem Beispiel wurde ein Vergleich zwischen dem Monomeren Verbindung 1 und Trimethylolethantriacrylat durchgeführt:

Lösung A

2,8 Gt der in Beispiel 3 angegebenen Mischpolymerisatlösung,
1,4 Gt Verbindung 1 und
0,05 Gt 1,1-Dimethoxy-1-phenylaceton in
22,0 Gt Propylenglykolmonomethylether.

Lösung B

2,8 Gt der in Beispiel 3 angegebenen Mischpolymerisatlösung,
1,4 Gt Trimethylolethantriacrylat und
0,05 Gt 1,1-Dimethoxy-1-phenylaceton in
22,0 Gt Propylenglykolmonomethylether.

Beide Lösungen wurden unter gleichen Bedingungen auf den in Beispiel 1 angegebenen Träger aufgeschleudert und wie in Beispiel 1 mit einer Deckschicht versehen. Belichtung, Entwicklung und Beurteilung erfolgten wie in Beispiel 1. Nach 40 Sekunden Belichtung wurden die Druckplatten eine Minute auf 100° C im Umlufttrockenschrank erwärmt. Die Anzahl der maximal geschwärzten Keilstufen betrug für Lösung A 8 und für Lösung B 5.

Beispiel 7

Eine Beschichtungslösung wurde aus
18,7 Gt der in Beispiel 3 angegebenen Terpolymerisatlösung,
9,3 Gt Verbindung 1,
0,163 Gt 9-Phenylacridin und
0,033 Gt Methylviolett (C.I.42 535) in
36,7 Gt Propylenglykolmonomethylether
bereitet und auf eine biaxial verstreckte 35 µm dicke Polyethylenterephthalatfolie so aufgeschleudert, daß ein Trockenschichtgewicht von 5 $g/m^2$ erhalten wurde. Die Schicht wurde 3 Minuten bei 100° C im Umlufttrockenschrank nachgetrocknet. Anschließend wurde die Schicht auf einen gereinigten Träger, der aus einem Isoliermaterial mit 35 µm Kupferauflage bestand, bei 115° C mit 1,5 m/s laminiert.

Die Schicht wurde mittels einer 5 kW-Metallhalogenidlampe mit 140 cm Abstand unter einem Stufenkeil wie in Beispiel 1 beschrieben 30 Sekunden belichtet und die Platte nach Abziehen der Folie mit 0,8%iger Sodalösung in einem Sprühprozessor 20 Sekunden entwickelt. Es wurden 5 vollvernetzte Keilstufen erhalten. Die vernetzte Schicht war gegen die in der Leiterplattentechnik übliche Eisen-III-chlorid-Lösung resistent. Die Ätzfestigkeit war gut.

Beispiel 8

In diesem Beispiel wurde ein Vergleich zwischen dem Monomeren Verbindung 1 und einem Urethangruppen enthaltenden Monomeren durchgeführt, das durch Umsetzen von 2,4,4-Trimethyl-hexamethylendiisocyanat und Hydroxyethylmethacrylat im Molverhältnis 1:2 erhalten wurde.

Lösung A

6,27 Gt der in Beispiel 3 angegebenen Terpolymerisatlösung,
1,4 Gt Verbindung 1,
0,058 Gt 9-Phenylacridin,
0,04 Gt 2,4-Bis-trichlormethyl-6-(4-styrylphenyl)-s-triazin,
0,0043 Gt des in Beispiel 3 angegebenen Azofarbstoffs und
0,0085 Gt des in Beispiel 1 angegebenen Azofarbstoffs in
30,0 Gt Propylenglykolmonomethylether.

Lösung B

6,27 Gt der in Beispiel 3 angegebenen Terpolymerisatlösung,
2,7 Gt einer 51.5%igen Lösung des 1:2-Umsetzungsprodukts aus 2,4,4-Trimethyl-hexamethylendiisocyanat und Hydroxyethylmethacrylat in Butanon,
0,058 Gt 9-Phenylacridin,
0,04 Gt 2,4-Bis-trichlormethyl-6-(4-styrylphenyl)-s-triazin,
0,0043 Gt des in Beispiel 3 angegebenen Azofarbstoffs und
0,0085 Gt des in Beispiel 1 angegebenen Azofarbstoffs in
30,0 Gt Propylenglykolmonomethylether.

Beide Lösungen wurden unter gleichen Bedingungen auf den in Beispiel 1 angegebenen Träger aufgeschleudert und wie in Beispiel 1 mit einer Deckschicht versehen. Die Platten wurden 40 Sekunden wie in Beispiel 1 belichtet, jedoch wurde auf den Belichtungskeil zusätzlich ein Graufilter mit der optischen Dichte d = 1,57 und einer gleichmäßigen Absorption über den gesamten Spektralbereich montiert. Nach dem Belichten wurde 1 Minute bei 100° C im Umlufttrockenschrank nacherwärmt und wie in Beispiel 1 entwickelt und beurteilt. Für Lösung A betrug die Anzahl der geschwärzten Keilstufen 6 und für Lösung B 4.

Beispiel 9

In diesem Beispiel wurde ein Vergleich zwischen dem Monomeren Verbindung 1 (Lösung A, Beispiel 8) und einem anderen stickstoffhaltigen Monomeren gemäß JP-A 50/129 214, N,N,N′,N′-Tetrakis-(2-hydroxy-3-methacryloyloxy-propyl)-ethylendiamin, durchgeführt.

Eine Beschichtungslösung B aus
6,27 Gt der in Beispiel 3 angegebenen Terpolymerisatlösung,
1,4 Gt Tetrakis-(2-hydroxy-3-methacryloyloxy-propyl)-ethylendiamin,
0,058 Gt 9-Phenylacridin,
0,04 Gt des in Beispiel 8 angegebenen Triazins,
0,0043 Gt des in Beispiel 3 angegebenen Azofarbstoffs und
0,0085 Gt des in Beispiel 1 angegebenen Azofarbstoffs in
30,0 Gt Propylenglykolmonomethylether
wurde unter den gleichen Bedingungen wie die Beschichtungslösung A aus Beispiel 8 auf den in Beispiel 1 beschriebenen Träger aufgeschleudert und wie in Beispiel 1 mit einer Deckschicht versehen. Belichtung, Nacherwärmung und Entwicklung erfolgte wie in Beispiel 8.

Nach 40 Sekunden Belichtung wurde von Muster B keine vollvernetzte Keilstufe erhalten. Muster A zeigte das in Beispiel 8 angegebene Ergebnis.

## Patentansprüche

1. Verbindung der allgemeinen Formel I

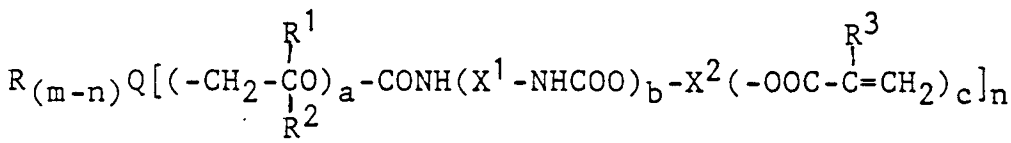 (I)

worin

Q

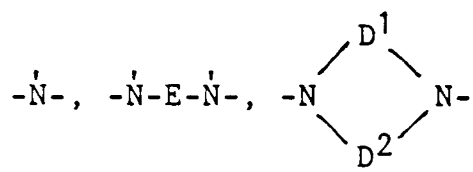

oder –S–

| | |
|---|---|
| R | eine Alkyl–, Hydroxyalkyl– oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl– oder Ethylgruppe, |
| $X^1$ | eine gesättigte Kohlenwasserstoffgruppe mit 2 bis 12 Kohlenstoffatomen, |
| $X^2$ | eine (c+1)–wertige gesättigte Kohlenwasserstoffgruppe, in der bis zu 5 Methylengruppen durch Sauerstoffatome ersetzt sein können, |
| $D^1$ und $D^2$ | jeweils eine gesättigte Kohlenwasserstoffgruppe mit 1 bis 5 Kohlenstoffatomen, |
| E | eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N–, O– oder S–Atome als Ringglieder enthält, eine Arylengruppe mit 6 bis 12 Kohlenstoffatomen oder eine heterocyclische aromatische Gruppe mit 5 oder 6 Ringgliedern, |
| a | 0 oder eine ganze Zahl von 1 bis 4, |
| b | 0 oder 1, |
| c | eine ganze Zahl von 1 bis 3, |
| m | je nach Wertigkeit von Q 2, 3 oder 4 und |
| n | eine ganze Zahl von 1 bis m |

bedeutet, wobei alle Reste gleicher Definition untereinander gleich oder verschieden sein können.

2. Verbindung gemäß Anspruch 1, dadurch gekennzeichnet, daß n = m ist.

3. Verbindung gemäß Anspruch 1, dadurch gekennzeichnet, daß E eine gesättigte Alkylengruppe mit 2 bis 4 Kohlenstoffatomen ist.

4. Verbindung gemäß Anspruch 1, dadurch gekennzeichnet, daß $R^3$ = $CH_3$ ist.

5. Verbindung gemäß Anspruch 1, dadurch gekennzeichnet, daß a + b = 1 oder 2 ist.

6. Durch Strahlung polymerisierbares Gemisch, das als wesentliche Bestandteile
   a) ein polymeres Bindemittel,
   b) einen Acryl– oder Alkacrylsäureester eines mehrwertigen Urethangruppen enthaltenden Alkohols und
   c) eine Verbindung oder eine Verbindungskombination, die unter Einwirkung aktinischer Strahlung die Polymerisation der Verbindung b) zu initiieren vermag,

   enthält, dadurch gekennzeichnet, daß der Acryl– oder Alkacrylsäureester eine Verbindung der Formel I gemäß Anspruch 1 ist.

7. Durch Strahlung polymerisierbares Gemisch nach Anspruch 6, dadurch gekennzeichnet, daß das Bindemittel wasserunlöslich und in wäßrig-alkalischen Lösungen löslich ist.

8. Durch Strahlung polymerisierbares Gemisch nach Anspruch 6, dadurch gekennzeichnet, daß es 10 bis 80 Gew.-% Acryl- oder Alkacrylsäureester, 20 bis 90 Gew.-% polymeres Bindemittel und 0,01 bis 10 Gew.-%, bezogen auf die nichtflüchtigen Bestandteile des Gemischs, des durch Strahlung aktivierbaren Polymerisationsinitiators enthält.

9. Durch Strahlung polymerisierbares Aufzeichnungsmaterial mit einem Schichtträger und einer durch Strahlung polymerisierbaren Schicht, dadurch gekennzeichnet, daß die durch Strahlung polymerisierbare Schicht aus einem Gemisch gemäß Anspruch 6 besteht.

**Claims**

1. A compound of the general formula I

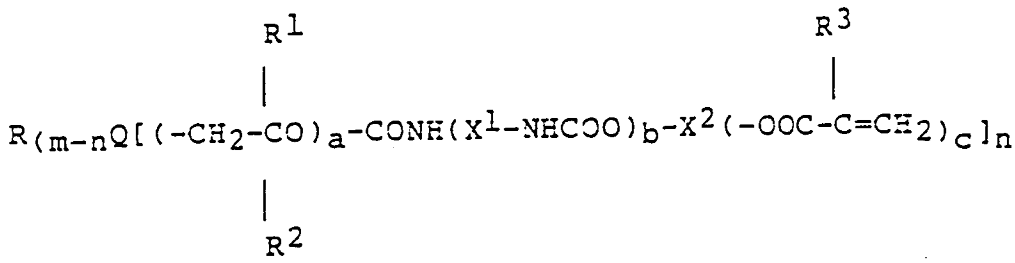

(I)

in which

| | |
|---|---|
| Q | denotes |
| | 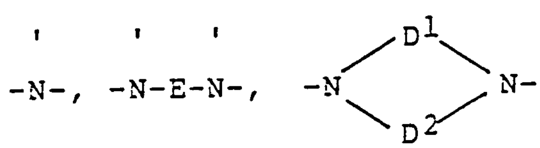 |
| | or -S-, |
| R | denotes an alkyl, hydroxyalkyl or aryl group, |
| $R^1$ and $R^2$ | each denote a hydrogen atom, an alkyl group or an alkoxyalkyl group, |
| $R^3$ | denotes a hydrogen atom, a methyl group or an ethyl group, |
| $X^1$ | denotes a saturated hydrocarbon group having 2 to 12 carbon atoms, |
| $X^2$ | denotes a (c+1)-valent saturated hydrocarbon group in which up to 5 methylene groups may be replaced by oxygen atoms, |
| $D^1$ and $D^2$ | each denote a saturated hydrocarbon group having 1 to 5 carbon atoms, |
| E | denotes a saturated hydrocarbon group having 2 to 12 carbon atoms, a cycloaliphatic group which has 5 to 7 ring members and which contains, where appropriate, up to 2 N, O or S atoms as ring members, an arylene group having 6 to 12 carbon atoms, or a heterocyclic aromatic group having 5 or 6 ring members, |
| a | denotes 0 or an integer from 1 to 4, |
| b | denotes 0 or 1, |
| c | denotes an integer from 1 to 3, |
| m | denotes 2, 3 or 4, depending on the valency of Q, and |
| n | denotes an integer from 1 to m, |

it being possible for all radicals of the same definition to be identical to or different from one another.

2. A compound as claimed in claim 1, wherein n = m.

3. A compound as claimed in claim 1, wherein E is a saturated alkylene group having 2 to 4 carbon atoms.

4. A compound as claimed in claim 1, wherein $R^3 = CH_3$.

5. A compound as claimed in claim 1, wherein a + b = 1 or 2.

6. A radiation-polymerizable mixture which contains, as essential constituents,
a) a polymeric binder,
b) an acrylate or alkacrylate of a polyvalent, urethane group-containing alcohol, and
c) a compound or combination of compounds which under the action of actinic radiation is capable of initiating polymerization of compound b),
wherein said acrylate or alkacrylate is a compound of the formula I as claimed in claim 1.

7. A radiation-polymerizable mixture as claimed in claim 6, wherein the binder is insoluble in water and soluble in aqueous-alkaline solutions.

8. A radiation-polymerizable mixture as claimed in claim 6, wherein 10 to 80 % by weight of acrylate or alkacrylate, 20 to 90 % by weight of polymeric binder and 0.01 to 10 % by weight of radiation-activatable polymerization initiator are contained, each time related to the non-volatile constituents of the mixture.

9. A radiation-polymerizable recording material comprising a layer support and a radiation-polymerizable layer, wherein the radiation-polymerizable layer comprises a mixture as claimed in claim 6.

**Revendications**

1. Composé de formule générale I

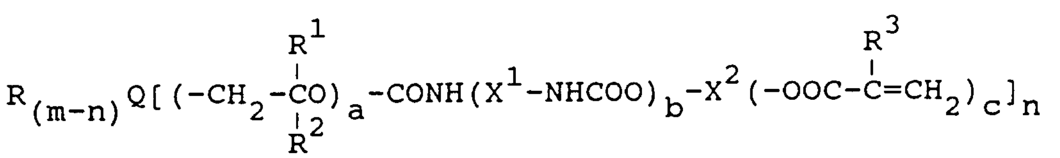 (I)

dans laquelle

| | |
|---|---|
| Q | représente |

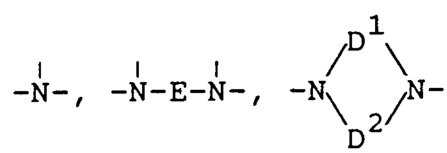

| | |
|---|---|
| | ou -S-; |
| R | représente un groupe alkyle, hydroxyalkyle ou aryle; |
| $R^1$ et $R^2$ | représentent chacun un atome d'hydrogène ou un groupe alkyle ou alcoxyalkyle; |
| $R^3$ | représente un atome d'hydrogène ou le groupe méthyle ou éthyle; |
| $X^1$ | représente un groupe hydrocarboné saturé ayant de 2 à 12 atomes de carbone; |
| $X^2$ | représente un groupe hydrocarboné saturé (c + 1)-valent, dans lequel jusqu'à 5 groupes méthylène peuvent être remplacés par des atomes d'oxygène; |
| $D^1$ et $D^2$ | représentent chacun un groupe hydrocarboné saturé ayant de 1 à 5 atomes de carbone; |
| E | représente un groupe hydrocarboné saturé ayant de 2 à 12 atomes de carbone, un groupe cycloaliphatique ayant de 5 à 7 chaînons formant le cycle, qui contient éventuellement jusqu'à 2 atomes de N, O ou S, en tant que chaînons formant le cycle, un groupe arylène ayant de 6 à 12 atomes de carbone ou un groupe aromatique hétérocyclique ayant 5 ou 6 chaînons formant le cycle; |
| a | est 0 ou un nombre entier allant de 1 à 4; |
| b | est 0 ou 1; |
| c | est un nombre entier allant de 1 à 3; |

m est 2, 3 ou 4, selon la valence de Q; et
n est un nombre entier allant de 1 à m,
tous les radicaux de même définition pouvant être identiques ou différents les uns des autres.

**2.** Composé selon la revendication 1, caractérisé en ce que n = m.

**3.** Composé selon la revendication 1, caractérisé en ce que E est un groupe alkylène saturé ayant de 2 à 4 atomes de carbone.

**4.** Composé selon la revendication 1, caractérisé en ce que $R^3 = CH_3$.

**5.** Composé selon la revendication 1, caractérisé en ce que a + b = 1 ou 2.

**6.** Composition polymérisable par irradiation, contenant, en tant que composants essentiels,
a) un liant polymère,
b) un ester acrylique ou alkacrylique d'un alcool polyvalent contenant des groupes uréthanne, et
c) un composé ou une association de composés permettant, sous l'effet d'un rayonnement actinique, d'amorcer la polymérisation du composé b),
caractérisée en ce que l'ester acrylique ou alkacrylique est un composé de formule I selon la revendication 1.

**7.** Composition polymérisable par irradiation selon la revendication 6, caractérisée en ce que le liant est insoluble dans l'eau et soluble dans des solutions aqueuses-alcalines.

**8.** Composition polymérisable par irradiation selon la revendication 6, caractérisée en ce qu'elle contient de 10 à 80 % en poids d'ester acrylique ou alkacrylique, de 20 à 90 % en poids de liant polymère et de 0,01 à 10 % en poids, par rapport aux composants non volatils de la composition, de l'initiateur de polymérisation activable par irradiation.

**9.** Matériau de reprographie polymérisable par irradiation, comportant un support de couche et une couche polymérisable par irradiation, caractérisé en ce que la couche polymérisable par irradiation est constituée d'une composition selon la revendication 6.